(19) Europäisches Patentamt
European Patent Office
Office européen des brevets

(11) **EP 1 264 354 B1**

(12) **EUROPEAN PATENT SPECIFICATION**

(45) Date of publication and mention
of the grant of the patent:
**20.06.2012 Bulletin 2012/25**

(51) Int Cl.:
*H01S 5/34* (2006.01)　　*B82Y 20/00* (2011.01)

(21) Application number: **01967647.7**

(22) Date of filing: **03.09.2001**

(86) International application number:
**PCT/IL2001/000828**

(87) International publication number:
**WO 2002/025745 (28.03.2002 Gazette 2002/12)**

(54) **SEMICONDUCTOR NANOCRYSTALLINE MATERIALS AND THEIR USES**

HALBLEITENDE NANOKRISTALLINE MATERIALIEN UND DEREN VERWENDUNG

MATERIAUX NANOCRISTALLINS SEMI-CONDUCTEURS ET LEURS UTILISATIONS

(84) Designated Contracting States:
**AT BE CH CY DE DK ES FI FR GB GR IE IT LI LU MC NL PT SE TR**

(30) Priority: **14.09.2000 IL 13847100**

(43) Date of publication of application:
**11.12.2002 Bulletin 2002/50**

(73) Proprietor: **YISSUM RESEARCH DEVELOPMENT COMPANY OF THE HEBREW UNIVERSITY OF JERUSALEM**
**91390 Jerusalem (IL)**

(72) Inventors:
- **BANIN, Uri**
  **90805 Mevasseret Zion (IL)**
- **CAO, Yun-Wei**
  **Gainesville, FL 32606 (US)**

(74) Representative: **Maureau, Philippe et al**
**Cabinet GERMAIN & MAUREAU**
**12, rue Boileau**
**B.P. 6153**
**69466 Lyon Cedex 06 (FR)**

(56) References cited:
WO-A-00/17655　　WO-A-00/71995
WO-A-01/71867　　JP-A- 2000 183 825

- **MILLO O ET AL: "Tunneling and optical spectroscopy of InAs and InAs/ZnSe core/shell nanocrystalline quantum dots" INTERNATIONAL CONFERENCE ON SEMICONDUCTOR QUANTUM DOTS (QD 2000), MUNICH, GERMANY, 31 JULY-3 AUG. 2000, vol. 224, no. 1, pages 271-276, XP002198576 Physica Status Solidi B, 1 March 2001, Wiley-VCH, Germany ISSN: 0370-1972**
- **CAO Y -W ET AL: "Colloidal synthesis and properties of InAs/InP and InAs/CdSe core/shell nanocrystals" SEMICONDUCTOR QUANTUM DOTS. SYMPOSIUM. (MATERIALS RESEARCH SOCIETY SYMPOSIUM PROCEEDINGS VOL. 571), SEMICONDUCTOR QUANTUM DOTS. SYMPOSIUM, SAN FRANCISCO, CA, USA, 5-8 APRIL 1999, pages 75-80, XP002196495 2000, Warrendale, PA, USA, Mater. Res. Soc, USA ISBN: 1-55899-478-5**
- **GUZELIAN A A ET AL: "COLLOIDAL CHEMICAL SYNTHESIS AND CHARACTERIZATION OF INAS NANOCRYSTAL QUANTUM DOTS" APPLIED PHYSICS LETTERS, AMERICAN INSTITUTE OF PHYSICS. NEW YORK, US, vol. 69, no. 10, 2 September 1996 (1996-09-02), pages 1432-1434, XP000629145 ISSN: 0003-6951 cited in the application**
- **ROGACH A ET AL: "COLLOIDALLY PREPARED HGTE NANOCRYSTALS WITH STRONG ROOM-TEMPERATURE INFRARED LUMINESCENCE" ADVANCED MATERIALS, VCH VERLAGSGESELLSCHAFT, WEINHEIM, DE, vol. 11, no. 7, 7 May 1999 (1999-05-07), pages 552-555, XP000849015 ISSN: 0935-9648**

- STEVE V. KERSHAW ET AL: "Development of IR-Emitting Colloidal II-VI Quantum-Dot Materials", IEEE JOURNAL OF SELECTED TOPICS IN QUANTUM ELECTRONICS, vol. 6, no. 3, 1 May 2000 (2000-05-01), XP011061779, IEEE SERVICE CENTER, PISCATAWAY, NJ, US
- KERSHAW S V ET AL: "Telluride colloidal quantum dots for telecommunication optical amplifiers", NANOSTRUCTURES AND QUANTUM DOTS/WDM COMPONENTS/VCSELS AND MICROCAVATIE S/RF PHOTONICS FOR CATV AND HFC SYSTEMS, 1999 DIGEST OF THE LEOS SUMME R TOPICAL MEETINGS SAN DIEGO, CA, USA 26-30 JULY 1999, PISCATAWAY, NJ, USA,IEEE, US, 26 July 1999 (1999-07-26), pages I5-I6, XP010352558, ISBN: 978-0-7803-5633-7

**Description**

**Field of the Invention**

The invention relates to a new method for the preparation of semiconductor composite nanocrystal materials having desirable luminescent properties, specifically high quantum yields and good photochemical stability with specific, desirable emittance wavelengths.

**Background of the Invention**

Semiconductor nanocrystals have been extensively investigated, since it is well known that the properties of the materials in this form, differ substantially from those of the bulk solid. The wavelength of light emitted from semiconductor nanocrystal quantum dots is tunable by their size as a result of the quantum-confinement effect [Nirmat et al., Acc. Chem. Res. 1999, 32, 407; Alivisatos A. P., Science 1996, 271, 933; Weller H., Angew. Chem. Int. Ed. Engl. 1993, 32, 41; Banin U., et al., Nature 1999, 400, 542]. Harnessing this emission for applications such as biological fluorescence marking, [Bruchez M., et al., Science 1998, 281, 2013; Chan W.C.W., et al., Science 1998, 281, 2016; Mitchell G.P., et al., J. Am. Chem. Soc. 1999 121, 8122] optoelectronic devices, and lasers [Colvin V.L., et al., Nature 1994, 370, 354; Dabboussi B.O., et al., Appl. Phys. Lett. 1995, 66, 1316; Schlamp, M.C., et al., J. Appl. Phys. 1997, 82, 5837; Mattoussi H., et al., J. Appl. Phys. 1998, 83, 7965] is challenging since stringent requirements are imposed. These include a high fluorescence quantum yield (QY), and stability against photodegradation. The required characteristics have proven difficult to achieve in semiconductor nanocrystals coated by organic ligands, due to imperfect surface passivation. In addition, the organic ligands are labile for exchange reactions because of their weak bonding to the nanocrystal surface atoms [Kuno M., et al., J. Chem. Phys. 1997, 106, 9869]. A proven strategy for increasing both the fluorescence QY and the stability of nanocrystals, while maintaining the solubility and chemical accessibility of the sample, is to grow a shell of a higher band gap semiconductor on the core nanocrystal, and for II-VI semiconductor nanocrystals, core/shell structures have been successfully developed, including the successful synthesis of highly emitting CdSe/ZnS nanocrystals. The synthesis of this material employs a high temperature route in trioctylphosphine (TOP)/trioctylphosphineoxide (TOPO) solution. Another approach employing a low temperature route has been used to grow CdSe/CdS core/shells in pyridine. These core/shell nanocrystals are still overcoated with outer organic ligands that maintain their solubility and chemical accessibility. They fluoresce in the visible range with a QY of 30-90%, and have increased photochemical stability [Hines, M. A., et al., J. Phys. Chem. 1996, 100, 468; Peng, X., et al., J. Am. Chem. Soc. 1997, 119, 7019; Dabbousi, B.O., et al., J. Phys. Chem. B. 1997, 101, 9463; Tian, Y., et al., J. Phys. Chem. 1996, 100, 8927; Cao, Y.W., et al., Angew. Chem. Int. Ed. Engl. 1999, 38, 3692].

In most previously fabricated composite core/shell combinations, both the shell material type and the shell thickness affected the optical and electronic properties of the semiconductor nanocrystals. Although this potentially provides extra degrees of freedom in tailoring the optical, electronic, electrical and chemical properties of semiconductor nanocrystals, the effect of shell type and thickness on wavelength emitted by the composite nanocrystal makes control during fabrication and long term stability of the characteristic wavelength of components manufactured from these materials difficult to achieve. It is noteworthy that most prior art core/shell combinations emit at visible and shorter wavelengths, whereas for telecommunications applications, near infra-red (NIR) emittances are technologically desirable as data carrying signals.

In modern data communication systems NIR optical signals including laser signals are modulated by the data to be transmitted, and are required to be carried from a first point to a second point, propagating along an optical fiber that connects the said two points. The magnitude of these data-carrying optical signals is attenuated as they travel along the optical fiber due to various losses, and therefore the signals require amplification by optical amplifiers located at predetermined points along the fiber. Conventional optical amplifiers suffer from limited tunability of both center-frequency and bandwidth, which is a major drawback. This limitation results from the fact that the amplification means employed by conventional optical amplifiers and transmitters is a plurality of individual doping atoms with limited available optical transitions.

Thus for a variety of telecommunication purposes there is a need for materials having emittance and optical gain as well as laser action, tunable in the Near IR (NIR) spectral range. This tunability will enable adjustment of the bandwidth and central frequency for optical amplification of a plurality of data carrying signals and their transmission around a stable center-frequency.

InAs nanocrystals can provide the flexibility required for this purpose. It has been demonstrated that it is possible to tune the band gap fluorescence of this material over the range of 800-1500 nm by varying the nanocrystal radii over the range 1-4 nm. However, the quantum yield QY of this material is low, and at room temperature it is limited to a mere 0.5-2%. These InAs nanocrystals are also easily degraded by oxidation and lack photo-stability. One known method of overcoming these, and other problems is to coat the nanocrystal with an appropriate shell, for example, CdS shells have been successfully applied to CdSe cores [Peng X. *et al. ibid.* 1997].

Whilst overcoming the stability limitations that are inherent to the non-shelled InAs, the band gap of previously disclosed shell materials generally modified the luminescence wavelength of the core nanomaterial [Cao, Y.W., *et al ibid.*]. Indeed applying a shell with a bandgap close to that of the core is a further known means of modifying the luminescence wavelengths of nanocrystals, and, although this potentially provides extra degrees of freedom in achieving specific emission wavelengths, the partial dependency of the emission wavelength of core/shell nanomaterials on the shell material and its dimensions makes control of this critical parameter during fabrication more difficult, as two extra process variables are introduced. The long-term stability in emission wavelength may also be detrimentally affected as changes in the outer layers of the shell can affect the wavelength of light emitted, and these outer layers interface with the environment and are thus susceptible to degradation processes in the course of time (aging). Nevertheless, high quantum yields are attainable with core/shell nanocrystals, and in a previous publication [Cao Y.W. and Banin U., Angew. Chem. Int. Ed. Engl. 1999, 38, 3692], the present inventors reported the growth of InAs/InP and InAS/CdSe core/shells. InP and CdSe shell materials have low lattice mismatches and small conduction band offsets compared with the core material. Thus, while it was not surprising that shells of these materials could be grown onto InAs cores, it was surprising that an impressive 20-fold enhancement of the room temperature QY to 20% was obtained for InAs/CdSe. Indeed this is better than the quantum yields of traditional organic NIR laser dyes.

Various manufacturing routes have been used for manufacturing semiconductor nanocrystals. The colloidal chemical route is widely applicable for synthesis of a variety of II-VI semiconductor nanocrystals such as CdSe [Murray, C.B., et al., J. Am. Chem. Soc. 1993, 115, 8706], as well as for III-V semiconductors such as InP [Micic, O.I., et al., J. Phys. Chem. 1994, 98, 4966; Nozik, A.J., et al., MRS Bull. 1998, 23, 24; Guzelian, A.A., J. Phys. Chem. 1996, 100, 7212] and InAs [Guzelian, A.A., et al., Appl. Phys. Lett. 1996, 69, 1462].

A specific known method uses a solution pyrolytic reaction of organometallic precursors in trioctylphosphine (TOP) [Peng, X., et al., A. P. J. Am. Chem. Soc. 1998, 120, 5343], and using this method, band gap fluorescences tunable between 800-1400 nm for radii ranging between 1 to 4 nm respectively, were observed, but the QY at room temperature was limited to 0.5-2%. The limited QY has been attributed to the surface passivation of the nanocrystals, which are overcoated by TOP ligands. TOP is a Lewis base that preferentially binds to cationic indium sites on the nanocrystal surface. This, along with the steric hindrance that the bulky TOP ligands impose on neighboring nanocrystal surface sites, leads to incomplete electronic passivation of surface dangling orbitals. The presence of such sites provides efficient pathways for nonradiative decay of the nanocrystal excited state, limiting the maximum fluorescence QY. Whereas the poor quantum yield can be improved by application of a shell, to date, such encapsulation has always modified the emission wavelengths in III-V cored nanocrystals.

International patent application WO-A-00/17655 discloses several semi-conductor core/shell nanocrystals, said core being a semiconductor nanocrystal comprising a first cationic specie comprising a Group III or a Group II element and a first anionic specie comprising a Group V or a Group VI element, and said core being encapsulated by a crystalline shell comprised of (Group III/Group V or Group II/Group VI) elements. Nevertheless, this document remains silent with regard to a method for producing such semi-conductor core/shell nanocrystals. The publication Cao Y. W. et al, Mat.Res.Soc.Symp.Proc. Vol. 571, 2000, 75-80 teaches a method of colloidal synthesis of InAs/InP core/shell nanocrystals in which the InP shell is formed at a temperature of 260°C.

It is an object of the present invention to provide a method for producing core/shell nanocrystals that overcome the drawbacks of prior art crystals.

It is a particular object of the present invention to provide a method for producing optically and chemically stable nanocrystals that luminesce at NIR wavelengths and that would be useful in various applications.

It is a further object of the present invention to provide a method for producing epitaxially grown shells as a means of encapsulating III-V semiconductor nanocrystals, thus forming core/shell nanocrystals such that the luminescent wavelength of said core/shell nanocrystals will depend on the dimensions and properties of the core, and will be substantially independent of the thickness and material of the shell.

### Summary of the Invention

The present invention relates to a method for the preparation of core/shell nanocrystals comprising an InAs nanocore encapsulated in a shell comprised of GaAs or InP, comprising the steps of

    (i) preparing a first stock precursor solution of In:As for nanocrystal cores having a molar ratio of In:As to nucleate InAs nanocrystals therefrom;

    (ii) preparing a second stock precursor solution of a shell material for nanocrystal shells of either GaAs or InP, the second stock precursor solution containing, in the case of GaAs shells, Ga:As in the molar ratio of 4:1 or, in the case of InP shells, In:P in a molar ratio from 1.2:1 to 1.5:1;

    (iii) injecting said first stock precursor solution at room temperature into TOP or TOP/TOPO solution at elevated temperature to nucleate core nanocrystals, with addition of further stock precursor solution as necessary, to achieve desired core dimensions;

(iv) precipitating core nanocrystals; and

(v) contacting the nanocrystals obtained in step (iv) with said second stock precursor solution of shell material in a TOP/TOPO solution to allow for growth of said shell on said core at a temperature of above 240°C.

The nanocrystals obtained by the method of the invention usually have organic ligands as a coating on their outer surfaces. Such organic ligands contribute to maintaining the solubility and chemical accessibility of the samples. The organic ligands may be substituted or removed. In the method of the invention, the first precursor stock solution of InAs cores preferably contains In:As at a molar ratio of from about 1:2 to about 1:1.5. The said shell material may be GaAs and said second precursor stock solution contains As:Ga at a molar ratio of 1:4. The said shell material may alternatively be ZnSe, where said second precursor stock solution contains Zn:Se at substantially equimolar ratio. Still alternatively the said shell material may be ZnS, where said second precursor stock solution contains S:Zn at substantially equimolar ratio.

## Brief Description of the Drawings

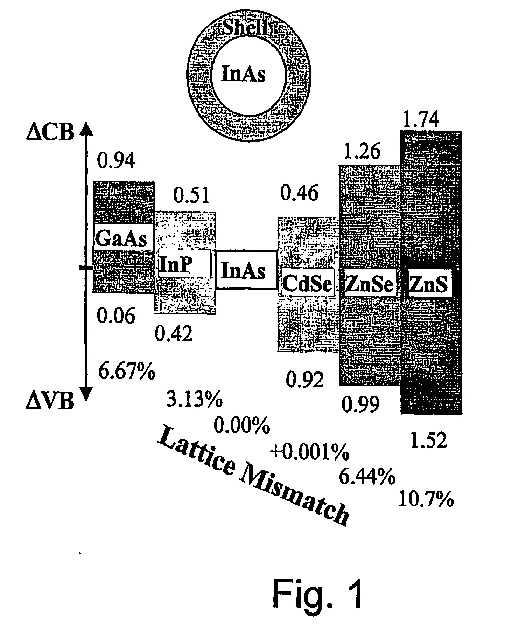

**Figure 1**: Summary of the band offsets (in eV) and lattice mismatch (in %) between the core InAs and various III-V semiconductor shells (left side), and II-VI semiconductor shells (right side). CB = conduction band; VB = valence band.

**Figure 2**: Evolution of the absorption spectra during the growth of InP shells on InAs cores with an initial radius of 1.3 nm. The InP shell thickness in number of monolayers is: (a) 0, (b) 0.5, (c) 1.1, (d) 1.7, (e) 2.5.

**Figure 3**: XPS survey spectrum for InAs cores with radius of 1.7 nm (lower trace), and for InAs/CdSe core/shells with shell thickness of 3 monolayers (top trace). The assignment of the peaks is indicated. The new peaks in the XPS spectrum for the core/shells associated with Cd and Se are emphasized in bold italic type.

**Figure 4**: Summary of high resolution XPS data for InAs/ZnSe and InAs/InP core/shells.
For InAs/InP core/shells, the log of the ratio of intensities of the $In_{3d5}$ to $As_{3d}$ is shown, versus the shell thickness. In both cases the ratio is normalized to the ratio in the cores. Squares: experimental data. Solid line: calculated ratio for core/shell structure. Dotted line: calculated ratio for alloy formation.

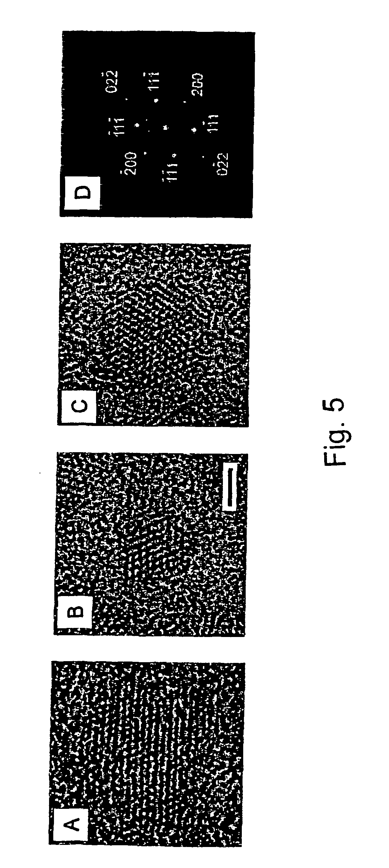

**Figure 5**: HRTEM images of InAs/InP core/shell (frame A, core radius 1.7 nm, shell thickness 2.5 nm), InAs core (frame B, core radius 1.7 nm), and InAs/CdSe core/shell (frame C, core radius 1.7 nm, shell thickness 1.5 nm). The scale bar is 2 nm. The nanocrystals are viewed along the [011] zone axis. Frame D shows the Fourier transform of image C, and the pattern corresponds to the diffraction pattern from the 011 zone of the cubic crystal structure.

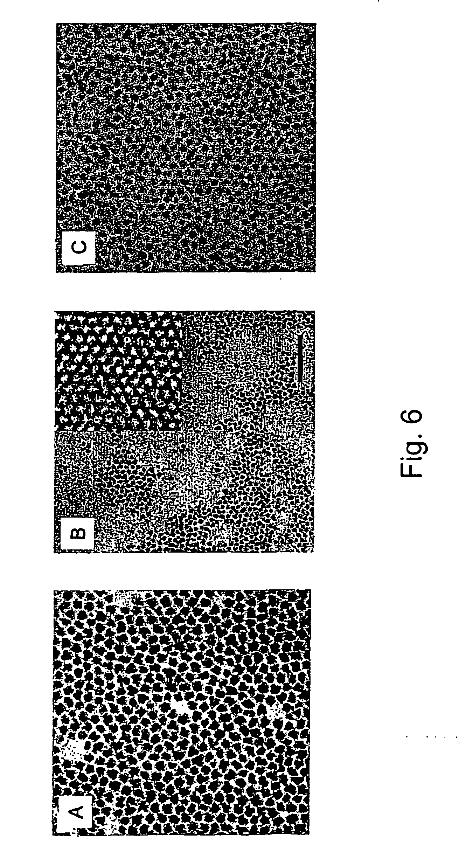

**Figure 6**: TEM images of InAs/InP core/shells (frame A, core radius 1.7 nm, shell thickness 2.5 nm), InAs cores (frame B, core radius 1.7 nm), and InAs/CdSe core/shells (frame C, core radius 1.7 nm, shell thickness 1 nm). The scale bar is 50 nm. The inset of frame B (70x70 nm), displays a portion of a superlattice structure formed from the InAs cores.

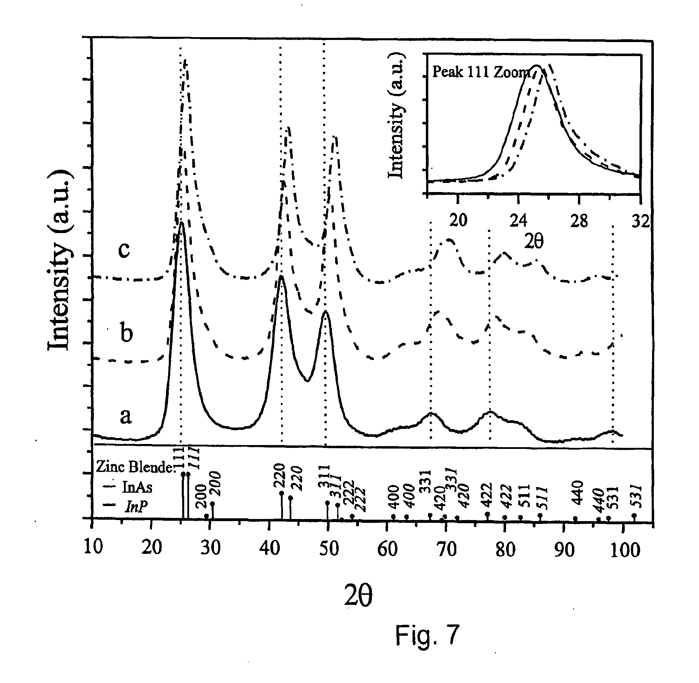

**Figure 7**: XRD patterns for InAs cores with radius of 1.7 nm (trace A, solid line), and InAs/InP core/shells with shell thickness of 2.4 monolayers (B, dashed line), and 6.2 monolayers (C, dot-dashed line). The inset shows a zoom of the 111 peak. The diffraction peak positions of bulk cubic InAs (dark) and InP (light, italic) are indicated.

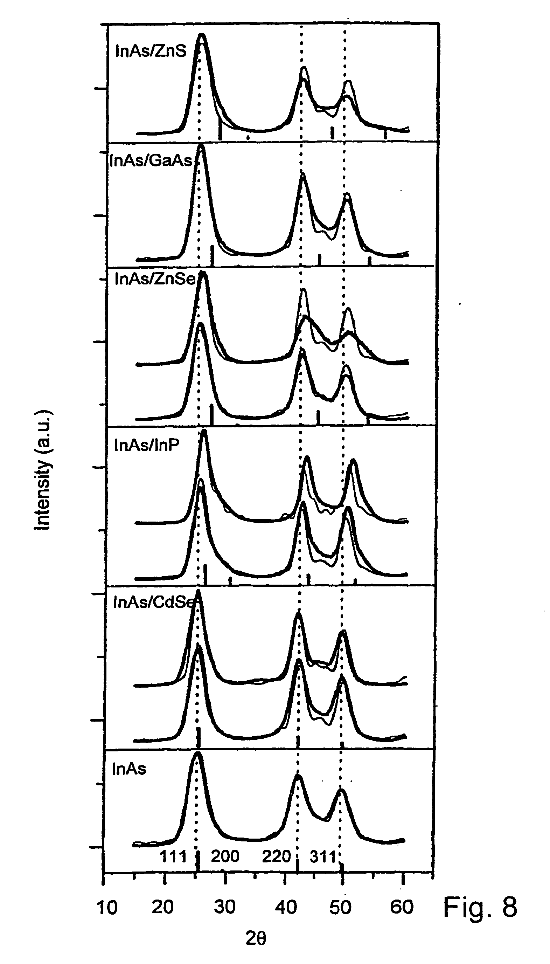

**Figure 8**: X-ray diffraction patterns for InAs cores and various core shells. The experimental curves (filled circles) are compared with the simulated curves (thin solid lines). The markers on the bottom of each frame indicate the diffraction peak positions and the relative intensities for the InAs core material (lower frame), and the various shell materials (other traces). The vertical dashed lines indicate the positions of the InAs core nanocrystal diffraction peaks.

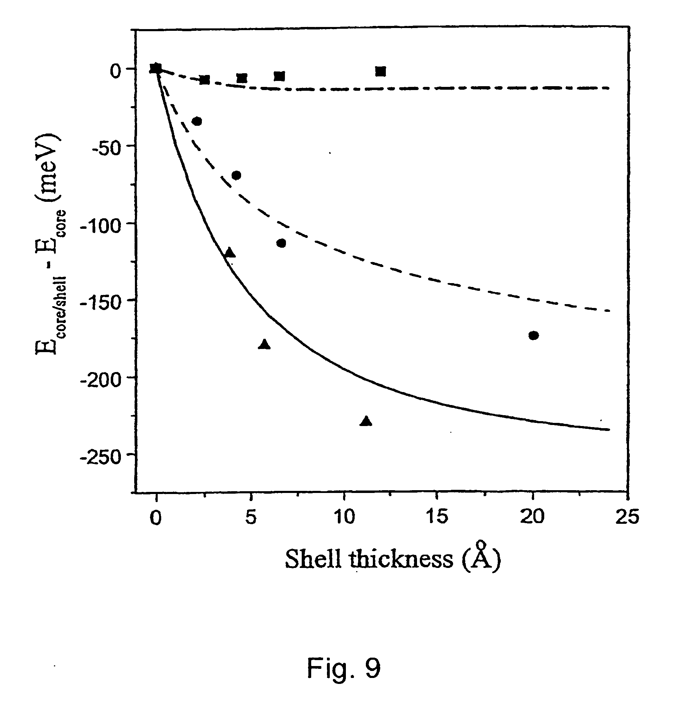

**Figure 9**: Experimental and calculated shifts of the band gap energy in various core/shells versus the shell thickness. InAs/ZnS core/shells: experimental data - squares, calculated shift of gap - dot-dashed line. InAs/InP core/shells: experimental data - circles, calculated shift of gap - dashed line. InAs/CdSe core/shells: experimental data - triangles, calculated shift of gap - solid line.

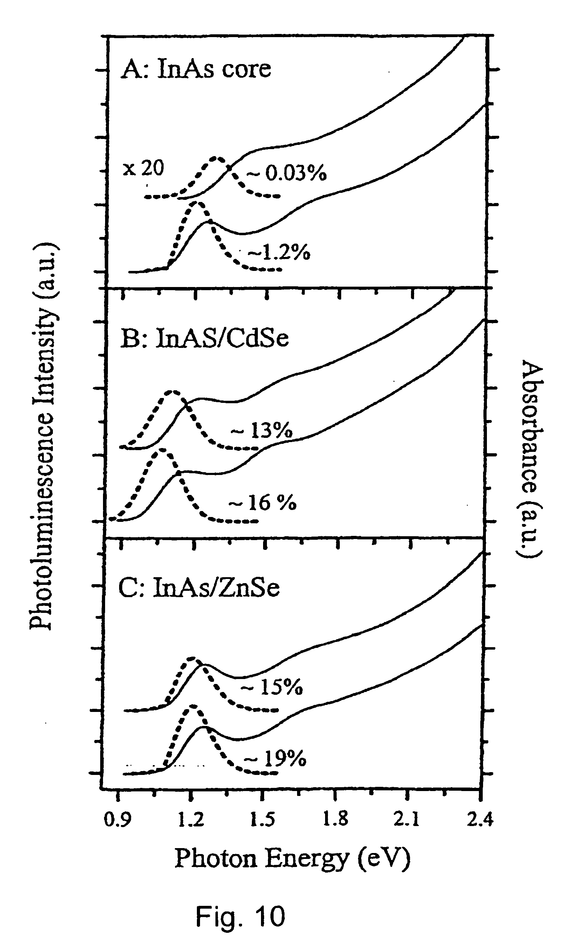

**Figure 10**: Comparison of stability of cores (frame A), InAs/CdSe core/shells (frame B), and InAs/ZnSe core/shells (frame C). Absorption spectra (solid lines) and PL spectra (dashed lines) are shown on the same energy scale for fresh (bottom traces in each frame), and for nanocrystals kept in an oxygen saturated solution for 10 months (top traces in each frame). The Photoluminescence QY is also indicated in each case.

## Definitions

The term nanocrystal as used herein refers to a single crystal particle of dimensions about 15 - 300 Angstroms, typically 20 - 100 Angstroms.

The terms "Near Infra Red" and "NIR" as used herein refer to light in the wavelength range of about 0.8-4.3 microns, but specifically 0.8 - 2 microns.

The term "semiconductor nanocrystal" as used herein refers to nanocrystal of Group III-V or II-VI, or core/shell nanocrystal where core and shell are made from Group III-V or Group II-VI compounds.

The term "ionic species" as used herein refers to atoms in the semiconductor crystal lattice that are formally positively or negatively charged, regardless of the actual degree of covalency exhibited by the interatomic bonding.

The term "cationic species" as used herein refers to atoms in the semiconductor crystal lattice that are formally positively charged.

The term "anionic species" as used herein refers to atoms in the semiconductor crystal lattice that are formally negatively charged.

The term "alloy" and variations thereof, as used herein refers to a complex nanocrystalline material having mixed atomic species, with either a plurality of cationic species or a plurality of anionic species (or both) co-precipitated out of solution, and deposited within the same layer of the nanocrystalline lattice. Thus an alloyed nanocrystalline core is a core such as InAsP, and an alloyed nanoshell is a shell such as ZnSSe.

## Detailed Description of the Invention

The present invention relates to a method for the preparation of core/shell nanocrystals that are based on a new concept for obtaining high quantum yield, stable Near Infra Red luminescent emitters for telecommunications applications. It is proposed to use a shell with a very different bandgap from that of the core as a means for encapsulating reactive cores, protecting them against chemical attack such as oxidation, thereby increasing chemical stability and quantum yield, whilst maintaining the luminescence wavelengths characteristic of the core. The range of wavelengths obtainable will thus depend only on the core material and its radius, due to the quantum-confinement effect, and will be substantially independent of the dimensions of the shell material. This important advantage provides means for greater control of the luminescence wavelengths of fabricated, cored nanocrystals, with the desired enhancement of photochemical stability. Extra degrees of freedom in engineering both core and shell materials are provided for by the new concept of alloyed core shell nanocrystals.

In contrast to the invention, in general with known core-shell combinations, particularly those based on InAs cores, the band gap of the shell materials causes modification of the luminescence wavelength of the core nanomaterial. The inventors have now significantly found that for specific material combinations it is possible to prepare core/shell nanocrystals having a shell that provides chemical and/or photochemical protection to the core, but does not modify the wavelength emitted. Removal of one of the variables that potentially affects the luminescence wavelength provides extra control during the preparation of the nanocrystals. These core/shell combinations provide greater stability, since although degradation to the shell may affect the QY, the wavelength of emitted light will not change. This finding enables material combinations that can be reliably manufactured and applied long term for various specific end-uses.

The inventors have succeeded in providing methods for the high temperature colloidal growth of various III-V and II-VI semiconductor shells on suitable, particularly InAs core nanocrystals, it being noted that growth of shells on nanocrystalline cores is significantly different from the epitaxial growth of thin films on semiconductor substrates.

In a first step of the method of preparation, stock solutions are prepared. In a second step, the InAs cores are prepared using substantially known techniques, and in the third step the shells are grown onto the cores using high temperature pyrolysis of organometallic precursors in a coordinating solvent. The core/shell growth may be monitored using absorption and photoluminescence spectroscopy. Specific parameters of the methods of preparation of core/shell nanocrystals are described in the Examples. The method of the invention enables control of the dimensions of both the core and shell layers, and thus nanocrystals are obtained having luminescence at specific, desired wavelengths. Core/shell nanocrystal synthesis should be controlled to allow shell growth while avoiding nucleation of nanocrystals of the shell material. In addition, alloying across the core/shell interface is to be avoided while maintaining crystallinity and epitaxial growth. Finally, solubility of the core/shell nanocrystals has to be maintained. This requires careful control of critical parameters, which are the temperature, nanocrystal concentration and solvent concentration in the growth solution, and the concentration and addition rate of the precursors. The temperature is particularly critical for core/shells with InAs

6

cores. Because of the higher reaction barriers, III-V semiconductor shells, in contrast to II-VI semiconductor shells, could only be grown at high temperatures. It was also found that even for II-VI semiconductor shells, the higher processing temperatures increased the fluorescence QY. For shell growth at 260°C, the maximum fluorescence QY of the products is ~4 times larger than that obtained at 160°C.

Core/shell nanocrystals formed by the method of the invention were characterized using transmission electron microscopy, X-ray photoelectron spectroscopy, and powder X-ray diffraction, and are exemplified and discussed in detail. X-ray photoelectron spectroscopy provides evidence for shell growth, further the X-ray diffraction peaks shift and narrow upon shell growth, providing evidence for an epitaxial growth mode. Simulations of the X-ray diffraction patterns reproduce both effects, and show that there is one stacking fault present for every four to five layers in the core and core/shell nanocrystals. The core/shell nanocrystals with InAs cores are suggested as a novel type of fluorophores covering the NIR spectral range and having high emission quantum yields and improved stability compared with traditional near IR laser dyes. The band gap energy of the core/shell nanocrystals of the invention is tunable in the NIR spectral range, covering the wavelengths that are important for telecommunication applications. The core/shell nanocrystals may be further developed to serve as efficient fluorescent labels for biological applications in the NIR range.

The core/shell nanocrystals with NIR luminescence can be incorporated into a light transmitting medium, such as an optical fiber or a polymeric film or a solution in an organic solvent such as hexane or toluene, as a signal amplification element, where, by supplying with suitable stimulation means, optical amplification is provided to telecommunication signals in an optical telecommunications line.

Thus, the invention also relates to an optical amplifier incorporating the core/shell nanocrystals of the invention. The center frequency and the bandwidth of these optical amplifiers is tunable by changing the mean and range of nanocrystals core dimensions. By controlling the core dimensions, it is possible to obtain a plurality of nanocrystals, each of which provides optical gain over a different range of wavelengths effectively broadening the bandwidth. Each nanocrystal can be used to amplify a data-carrying optical signal by exciting the nanocrystal with electrical or electromagnetic energy such as "pumping" light using a diode laser or other suitable light source. The nanocrystal can be integrated into said light transmitting medium, and concurrently illuminated with the pumping coherent light and the data-carrying (modulated) optical signal. The resulting signal is a data-carrying optical signal with higher magnitude that can be propagated along the fiber until the next amplification point. Data communication systems require optical transmission of a plurality of data-carrying optical signals, potentially of different wavelengths via the same fiber, this requires an increased optical bandwidth for the amplifier. Such wideband optical amplification is implemented, according to the present invention, by integrating a plurality of nanocrystals along a segment of the medium where amplification is required. Each of the integrated nanocrystal has different core dimensions and therefore covers (amplifies) a different optical bandwidth. In addition, the core nanocrystal may be doped, with erbium and/or other suitable dopants, to further modify its optical properties. Therefore, when pumped by laser radiation, the integrated structure provides optical gain in a bandwidth that is essentially equivalent to the sum of the bandwidths of each individual nanocrystal.

The shell of each nanocrystal eliminates the changes in the center frequency and the bandwidth of each individual nanocrystal that might result from environmental conditions/stresses applied to the fiber. In addition, the shell improves the gain obtained from each nanocrystal, and therefore the overall efficiency of the wideband optical amplifier.

Throughout this specification and the claims which follow, unless the context requires otherwise, the word "comprise", and variations such as "comprises" and "comprising", will be understood to imply the inclusion of a stated integer or step or group of integers or steps but not the exclusion of any other integer or step or group of integers or steps.

The following examples are provided merely to illustrate the invention and are not intended to limit the scope of the invention in any manner.

## Examples

**Chemicals**: gallium (III) chloride ($GaCl_3$), indium (III) chloride ($InCl_3$), tris(trimethylsilyl) phosphide {$(TMS)_3P$}, dimethylcadmium ($Cd(CH_3)_2$) were purchased from Strem and used without further purification. Trioctylphosphine (TOP, 90% purity), trioctylphosphine oxide (TOPO, 90% purity), selenium (Se), hexamethyldislthiane {$(TMS)_2S$}, 2M of dimethylzinc {$Zn(CHs)_2$} in toluene solution, anhydrous methanol, anhydrous toluene were purchased from Aldrich. TOP and TOPO were purified by vacuum distillation [Guzelian, A.A., et al., J. Phys. Chem. 1996, 100 7212], and kept in the glovebox. Tris(tri-methylsilyl) arsenide {(TMS)sAs} was prepared as detailed in the literature [Becker, G., et al., Anorg. Allg. Chem., 1980, 462, 113].

## Synthesis of InAs core nanocrystals

Details of this synthesis are reported elsewhere [Guzelian, A.A., Appl. Phys. Lett. 1996, 69, 1462; Peng, X., J. Am. Chem. Soc. 1998, 120, 5343]. A typical preparation is exemplified. 3 g of TOP were heated in a three-neck flask on a Schlenk line under Ar atmosphere to a temperature of 300°C with vigorous stirring. 1 ml of stock solution (see below) was rapidly injected and the solution was cooled to 260°C for further growth. The growth was monitored by taking the absorption spectra of aliquots extracted from the reaction solution. Additional injections were used to grow larger diameter cores. Upon reaching the desired size, the reaction mixture was allowed to cool down to room temperature and was transferred into the glove box. Anhydrous toluene was added to the reaction solution, and the nanocrystals were precipitated by adding anhydrous methanol. The size distribution of the nanocrystals in a typical reaction was on the order of $\pm 15$ %. This was improved using size selective precipitation with toluene and methanol as the solvent and nonsolvent respectively.

## Stock solution of InAs core

Under Ar atmosphere, 9 g of $InCl_3$ was dissolved in 30 ml of TOP at 260°C with stirring. The solution was then cooled, and taken into the glove box. The stock solution was prepared by mixing a desired amount of $(TMS)_3As$ and $InCl_3$-TOP solution with the As:In molar ratios at 1:2 or 1:1.5.

## GaAs and InP shells

TOP capped InAs cores (5-20 mg) were dissolved in 3-6 g of TOP in a three-necked flask. Under Ar flow on a Schlenk line, the nanocrystal solution was heated to 260°C, and the shell precursor solution of GaAs or InP(see below) was introduced into the hot solution by drop-wise addition. The growth of core/shells was monitored by UV-VIS spectroscopy of aliquots taken from the reaction flask. After growing the desired shell thickness, the reaction mixture was cooled to room temperature. InAs/GaAs or InAs/InP core/shell nanocrystals passivated by TOP were obtained by precipitation using a mixture of methanol and toluene.

## Stock solution for shells

**GaAs shell precursor solution**: 300 mg of $GaCl_3$ was dissolved in 10 ml of TOP by stirring in the glove box. Then the stock solution was prepared by mixing $(TMS)_3As$ and $GaCl_3$ TOP solution with the As:Ga molar ratios at 1:4.
**InP shell precursor solution**: concentrated $InCl_3$ TOP solution for InAS core growth was diluted ten times with TOP. This diluted $InCl_3$ TOP solution was then mixed with $(TMS)_3P$ at P:In molar ratios of 1:1.2~1.5.

## Characterization

The crystals so formed were fully characterized by UV-VIS-NIR absorption spectra using a Shimadzu UV1601 or UV 3101pc spectrophotometer. Nanocrystals were dissolved in toluene for the measurement.
Photoluminescence and fluorescence QY were determined. The photoluminescence by using a He-Ne laser (632 nm, output power: 3 mW, spot size: 3 mm) or a monochromatized arc Xenon lamp (150 W) as the excitation source. The excitation beam was chopped at 270 Hz. The emission was collected at a right angle configuration, dispersed by a monochromator and detected by a liquid nitrogen cooled InGaAs diode or a InGaAs PIN photodetector with lock-in amplification. The fluorescence spectra were corrected for the response of detection system, using a correction curve determined by measuring the spectrum of a standard tungsten-halogen lamp.
Room temperature fluorescence quantum yields (QYs) of the nanocrystal solutions were determined by comparing the emission with the integrated emission of the laser dye IR 125 in dimethyl sulfoxide (DMSO) with equal optical densities at the excitation wavelength. In a typical experiment, the fluorescence of a solution of core InAs nanocrystals in toluene was measured and in the same conditions the fluorescence of the dye solution was measured using 764 nm excitation from the monochromatized Xe lamp, which is close to the peak of the dye absorption. Both solutions had an equal optical density at 764 nm, of -0.3. The QY of the core InAs nanocrystals was obtained by comparing the integrated fluorescence intensity of these two solutions after correction for the detection system response,. The refractive index of the two solvents, toluene and DMSO, are nearly identical (1.49 versus 1.48 respectively), and therefore the quadratic refractive index correction which amounts to a factor of only 1.02 was not needed [Demas, J.N., et al., J. Phys. Chem. 1971, 75, 991]. The emission of the core/shell solution in toluene and of InAs solution with equal optical density (-0.3) at 632 nm were measured, and the corrected integrated intensity of the fluorescence of these solutions was compared, allowing the QY for core/shells to be calculated.
**X-ray photoelectron spectroscopy (XPS)**: XPS measurements were performed on a Perkin-Elmer PHI 5600 ESCA system. Data were obtained with Al $K_\alpha$ radiation (1486.6 eV) at 200 W. Survey spectra were collected in the range of 0~1400 eV with a 187.85 eV pass energy detection. High-resolution spectra for the quantitative calculations were obtained at a 11.75 eV pass energy with a resolution of 0.025 eV per step interval. Typical high-resolution scans were collected for 10~30 minutes per element. Measurements were performed at pressures lower than $1\times10^{-8}$ Torr. Spectra were calibrated using the position of the Au 4f peaks present in all spectra as a standard. These measurements were performed on nanocrystal films of monolayer thickness, linked by hexane dithiols to a Au coated substrate [Katari, J.E.B., J. Phys. Chem. 1994, 98, 4109].

**X-ray Diffraction (XRD)**: Powder X-ray diffraction patterns were measured on a Philips PW 1830/40 X-ray diffractometer with Cu $K_\alpha$ radiation. Approximately 10 mg of nanocrystals were dispersed in minimum volume of toluene. The nanocrystal solution was deposited onto low scattering quartz plates, and the solvent was evaporated under mild vacuum.

**Transmission Electron Microscopy (TEM)**: High-resolution TEM (HRTEM) images were obtained using a JEOL-JEM 2010 electron microscope operated at 200 kV. Low-resolution TEM images were obtained using a Philips CM 120 microscope operated at 120 kV. Samples for TEM were prepared by depositing a drop of a nanocrystal solution in toluene onto a copper grid supporting a thin film of amorphous carbon. The excess liquid was wicked away with filter paper, and the grid was dried in air.

The shell thickness dimensions obtained are reported in monolayers (ML), with 1 ML equal to the $d_{111}$ lattice spacing of the shell material (e.g. $d_{111}$=3.498 Å for InAs). This dimension is determined by measuring the sizes of nanocrystals from low resolution TEM images of core and core/shell nanocrystals grown on these cores. The average radius of the cores is subtracted from the average radius of core/shells as determined from these measurements. Although the sizes of nanocrystals measured by low resolution TEM images are systematically larger than those measured by HRTEM images as is known from other studies, the relative measurement with the low resolution TEM that was employed for shell thickness determination avoids this error. For several samples, the shell thickness from HRTEM was also determined, and the shell thicknesses were consistent with those from the low resolution TEM. The radius of the core nanocrystals reported in this study was obtained from a sizing curve measured from HRTEM of InAs nanocrystals as determined previously [Banin, U., et al., J. Chem. Phys. 1994, 98, 4109].

**Results**

**1. Synthesis of core/shell nanocrystals**

The preparation of the InAs core/shell nanocrystals was carried out in a two step process:

(a) In the first step, the InAs cores were prepared using the injection method with TOP as solvent. This allowed the obtaining of hundreds of mg of nanocrystals per synthesis [Peng X., *et al., ibid*.]. Size-selective precipitation was used to improve the size distribution of cores to σ~10%.
(b) In the second step, the shells of the various materials were grown onto these cores.

For growth of GaAs and InP shells a minimum temperature of T>240°C is required. This temperature is needed to overcome the reaction barrier for the precursors. Above this limit, controlled growth of InP shells of varying thickness on cores with different sizes was achieved. However, in contrast to the InP shells, only thin GaAs shells were obtained with GaAs growth limited to a thickness of less than two monolayers. An additional difference between the GaAs and the InP shells is in the solubility of the core/shell nanocrystals of each kind. InAs/InP core/shells are readily soluble in organic solvents, after precipitation of the nanocrystals from the growth solution. Special conditions are required for obtaining good solubility of the InAs/GaAs core/shells. An increased ratio of Ga:As (4:1) in the precursor solution was used, and the InAs/GaAs nanocrystals were annealed in the growth solution for several hours, at a temperature of 260°C.

**2. Optical Characterization**

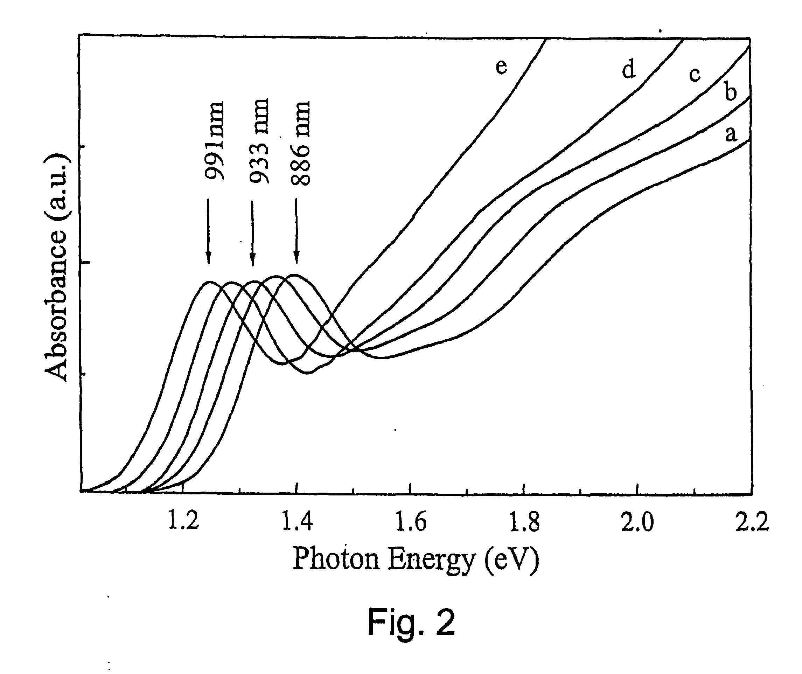

The most direct and immediate probes for shell growth are the absorption and fluorescence spectra. Fig. 2 shows the sequence of absorption spectra measured for aliquots taken from the reaction solution during the growth of InP shells on InAs cores with an initial radius of 1.3 nm. The first absorption peak shifts to the red as we reported earlier for growth of an InP shell on a bigger core [Cao, Y.W., *et al. ibid*.]. The red shift occurs because the conduction band offset between InAs and InP is smaller than the confinement energy of the electron, and as the shell grows, the electron wavefunction extends to a larger box and its confinement energy is lowered. As the electron effective mass, $m_e^*$, in InAs is extremely small ($m_e^*$=0.024$m_e$, $m_e$ is the mass of the free electron) [Madelung, O. et al., ed. Landolt-Bornstein: Numerical Data and Functional Relationships in Science and Technology, New Series, Vol. 17; Springer-Verlag: New York, 1982], it is highly delocalized, and a large potential step is required to confine it to the core. The observed red shift also rules out the formation of an alloy of the core and shell materials at the interface, for in the case of alloying the band gap would be expected to be intermediate between those of similar size nanocrystals of the composing materials, InP and InAs. The band gap of bulk and of nanocrystalline InP is substantially larger compared with the band gap of InAs and thus a blue shift is expected for the alloy nanocrystal. The spectral features remain sharp during the reaction, indicating that the growth is controlled and that the size distribution is maintained. However, the fluorescence of the InAs/InP core/shells is quenched substantially as compared to the original cores.

### 3. Chemical and Structural Characterization

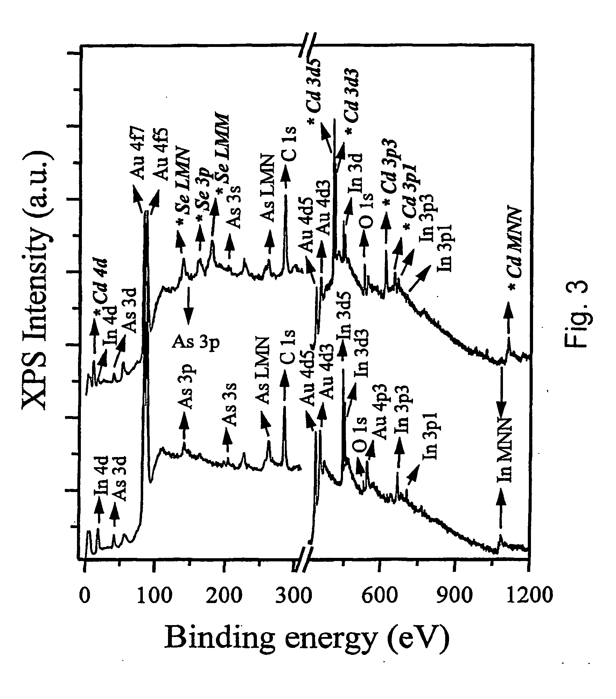

X-ray Photoelectron Spectroscopy (XPS) was used to examine the chemical composition of the core/shells [Hoener, C.F., et al., J. Phys. Chem. 1992, 96, 3812]. Fig. 3 shows the XPS survey spectra for InAs cores with 1.7 nm radii and for InAs/CdSe core/shells prepared with similar cores but with shell thickness of 3 monolayers. Indium and arsenic peaks are clearly resolved for the cores (lower spectrum). Additional peaks belonging to Cd and Se, the shell materials, can be identified in the core/shells (top spectrum). The ratio of the XPS peak heights between core and core/shell for the core atoms, is energy dependent. The relative intensity of the peaks at high binding energies (e.g. $In_{MNN}$), which have a small kinetic energy and thus a small escape depth, is quenched more upon shell growth, compared with the peaks at small binding energy and large escape depth (e.g. $As_{LMN}$).

High resolution XPS provides quantitative evidence for shell growth based on the finite escape depth, $\lambda$, of photoelectrons from the core atoms. The typical escape depths are of the same order of magnitude as the shell thickness and the photoelectron signal from core atoms should decrease accordingly in the core/shell structure. The XPS signal intensity, I, at depth z is given by [Katari, J.E.B., et al., ibid.]:

$$I = nf\sigma y F(KE) \int_V e^{-z/\lambda(KE)} \qquad \text{eq. 1}$$

where n is the density of atoms, f is the X-ray flux, $\sigma$ is the cross section of the photoelectronic process, y is the photoelectron emission quantum yield, F(KE) is the instrument response function which depends on the energy KE. For a flat geometry, the value of the integral in equation 1 is $\lambda$ - the photoelectron escape depth, and then equation 1 can be simplified to I=nS, where S is the atom and kinetic energy dependent sensitivity factor. For the nanocrystals, where the length of radius r is of same order of magnitude as the wavelength $\lambda$, the assumption of flat geometry has to be corrected by carrying out the integration in eq. 1 over the nanocrystal volume. For this integration a spherical shape for the nanocrystals is assumed [Katari et al.; Hoener et al.; ibid.].

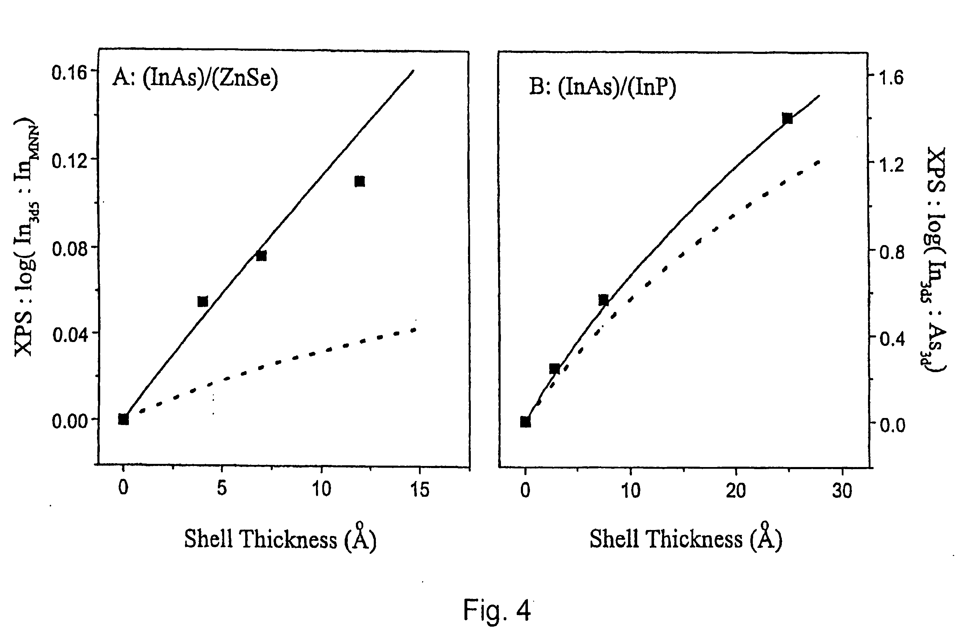

The application of XPS to the study of shell growth is demonstrated in Fig. 4. Figure 4 shows the XPS data for InAs/InP core/shells. The figure shows the experimental results (squares) for the log of the ratio of the $In_{3d5}$ peak to the $As_{3d}$ peak normalized to the ratio in the core. The ratio increases upon shell growth. This is mainly due to the addition of In atoms in the shell region.

Further increase of the ratio should result from the reduction in the relative Arsenic signal due to the finite escape probability of the photoelectrons through the shell region. The experimental results are well fitted by the simulation of the ratio assuming a core/shell configuration (solid line). The simulated curve for alloy formation (dashed line), predicts a lower ratio although it also increases with shell growth because of the addition of In atoms. The following photoelectron escape depths ($\lambda$) were used in the calculations in the InAs core region: $As_{3d}$: 24.8 Å, $In_{3d5/2}$: 19.2 Å. The respective values in the InP shell were 24 Å, and 18.6 Å (These wavelengths were taken from S. Tanuma ibid.).

**Transmission Electron Microscopy.** Fig. 5 presents HRTEM images of core and core/shell nanocrystals. Frame B shows a micrograph of an InAs core with radius of 1.7 nm, and frames A and C respectively show InAs/InP and InAs/CdSe core/shell nanocrystals with thick shells grown on similar cores. The crystalline interior is viewed along the [011] zone axis of the cubic lattice. The cubic lattice is resolved for the InAs/CdSe core/shell as well, as clearly revealed also by the Fourier transform of the image presented in Fig. 5D. CdSe nanocrystals grown in such conditions form the wurtzite structure, but here they adopt the cubic structure on the InAs core. For all three cases, the fringes are visible across the entire nanocrystals in accordance with epitaxial shell growth in these particles.

Fig. 6 shows TEM images for InAs/InP core/shells with shell thickness of 2.5 nm (A), close packed nanocrystal monolayers of InAs cores having radii of 1.7 nm (B), and InAs/CdSe coreshells with shell thickness of 1 nm grown on similar cores (C). Furthermore, InAs core nanocrystals can form superlattices (SL), as seen in the inset of frame B. The superlattice is prepared by slow solvent evaporation, and its formation further indicates that the size distribution of the InAs cores is narrow [Murray, C.B., et al., Science, 1995, 270, 1335]. The width of the size distribution of cores was estimated from the TEM measurements to be ~8% ($\sigma$). For core/shells the distribution after growth of thick shells broadens to ~12%.

The shell thickness determined from TEM was also used to estimate the yield of shell growth. This yield is material dependent. For CdSe and InP shells, the growth yield is larger than 90%. For thin ZnSe and ZnS shells, the growth yield ranges from 60-80% depending on the TOP/TOPO ratio. Higher growth yields are obtained for larger TOP fractions. The growth yield in thick ZnSe and ZnS shells (over 3 monolayers), increases to over 90%.

**X-ray Diffraction**: Powder XRD patterns for the InAs core, 1.7 nm in radius, and for InAs/InP core/shells with increasing thickness are presented in Fig. 7. The InAs XRD pattern consists of the characteristic peaks of cubic InAs, with broadening due to the finite crystalline domain size [Guzelian, A.A., et al., Appl. Phys. Lett. 1996, 69, 1462]. With InP shell growth, the diffraction peaks shift to larger angles consistent with the smaller lattice constant for InP compared with InAs. The shift is most clearly resolved for the high angle peaks. In addition, the diffraction peaks narrow. This was demonstrated for the (111) peak shown in the inset of Fig. 8. This narrowing indicates that the crystalline domain is larger for the core/shells providing direct evidence for epitaxial growth of the shell [Cao, Y.W., *et al., ibid.*]. The relatively simple diffraction pattern for cubic InAs enables clear observation of peak narrowing as the shell is grown.

The XRD patterns for a series of core/shells with different shell materials and varying thickness are displayed in Fig. 8 (filled circles). The general pattern of the cubic lattice is maintained for all materials. The diffraction peaks narrow with shell growth in the case of CdSe, ZnSe, and GaAs shells for the reasons discussed above. This is not the case for ZnS, probably due to the very large lattice mismatch of ZnS and InAs (10.7%). In this case, the large strain may lead to cracking at the InAs/ZnS interface during early growth stages. Moreover, ZnS nanocrystals in these growth conditions preferentially form the wurtzite structure, which may create additional defects upon shell growth.

To further prove this interpretation of the XRD data and to obtain more quantitative information about the core/shell structures, the powder diffraction patterns were simulated. The method of calculation follows that published earlier [Wickham, J.N., et al., Phys. Rev. Lett., 2000, 84, 923]. Simulated nanocrystal structures were built by stacking planes along the (111) axis of the cubic lattice. The sum of the specified core radius, $r_c$, and shell thickness, $r_s$, was used to carve out the nanocrystal assuming a spherical shape. The possibility of surface disorder, as well as the temperature effect, were added.

The experimental data (filled circles), and the simulation results (thin lines) for the core and a series of core/shells are displayed in Fig. 8. The simulation of the cores fits the experimental data very well. The fit was obtained using the simulated XRD pattern for an equally weighted combination of two kinds of core nanocrystal structures with the same radii, differing in the (111) plane stacking sequence as detailed in Table 1 [Wickham, J.N., et al., Private communication].

**Table 1. Parameters used in the XRD simulations.**

|  | radius or shell thickness (Å) | Number of atoms | Number of stacking faults | Planes per stacking fault |
|---|---|---|---|---|
| Core (a)* | 34 | 751 | 3 | 3.7 |
| Core (b)* | 34 | 729 | 3 | 3.7 |
| CdSe shell | 4.5 | ~1500 | 3 | 4.5 |
|  | 11 | ~3400 | 4 | 4.3 |
| InP shell | 8 | ~2400 | 3 | 5.2 |
|  | 21 | ~8300 | 6.5 | 3.6 |
| ZnSe shell | 3.6 | ~1300 | 3 | 4.4 |
|  | 8 | ~2400 | 3 | 5.3 |
| GaAs shell | 4.5 | ~1500 | 3 | 4.6 |
| ZnS | 4.5 | ~1500 | 3 | 4.6 |
| The stacking sequence for the two cores, along the (111) direction, are a: 12312121321 and b: 12321312321. | | | | |

Both nanocrystal structures have 3 stacking faults. The experimental diffraction intensity between the (220) and the (311) peaks does not go to zero, while in the simulated pattern for nanocrystals without stacking faults the value is close to zero. Thus, three stacking faults along the (111) direction are required to quantitatively reproduce the experimental pattern. Introduction of surface disorder has little effect on the simulated patterns. The shape of the core was also varied, and for cubic, tetrahedral and spherical shapes the patterns are very similar. The same combination of core structures was used in all of the simulations of the XRD patterns for the core/shell structures. The relevant parameters for the structures used in the simulation are given in Table 1.

For InAs/CdSe core/shells, the lattice mismatch is zero. The experimental peak positions do not shift with shell growth. This is well reproduced in the simulation. An additional stacking fault was added in the shell region for the thicker shell of three monolayers, to better reproduce the experimental pattern.

For the other core/shells there is a lattice mismatch, which ranges from 3.13% for InP, to 10.7% for ZnS. A gradual shift of the diffraction peaks with shell growth towards larger angles is observed for these core/shells (Fig. 10). This implies that the lattice spacing is modified in the shell region, for in order to achieve epitaxial growth mode, atoms in both core and shell regions at the core/shell interface must have identical lattice spacings. To simulate the smooth switching of the lattice spacing from the core to the shell, a Fermi-like switching function was used:

$$a(r) = a_s + \frac{a_c - a_s}{e^{(r-r_c)/T} + 1} \qquad \text{eq. 2}$$

where a(r) is the lattice constant at radius r, ac and $a_s$ are the lattice spacings for the bulk core and shell materials respectively, $r_c$ is the radius of the core, and T is the switching length factor. This switching provides a physical model for understanding the epitaxial growth mode, while reproducing the observed change in the peak positions upon shell growth. The effect of switching on the diffraction patterns of core/shells was studied by varying T from 0 to 9 Å. It was found that the diffraction pattern is only slightly sensitive to the magnitude of T. This may be due to the inherent symmetry of the Fermi-like switching function, eq. 2, in the core and shell regions. Over the switching range, the lattice constant changes to smaller values for the core relative to that for pure InAs, and increases in the shell relative to the respective pure materials. The X-ray scattering factor for InAs is larger than that of all shell materials [Mann, B., Acta Cryst., 1968, A 24, 321], and the overall effect is that the peak positions shift slightly to high angles with increasing T. In the simulations, T, the switching length factor, was set to 6 Å corresponding to a shell thickness of approximately two monolayers.

The simulated patterns reproduce the two main effects observed with shell growth for InAs/InP, InAs/ZnSe, and InAs/GaAs core/shells, namely the shifting of all the diffraction peaks to larger angles, and the narrowing of the peaks (Fig. 8). This provides further evidence for epitaxial shell growth. For InAs/ZnS, no narrowing was observed in the experimental diffraction pattern indicating that in InAs/ZnS core/shells, the interface region is not fully epitaxial. Similar to the case of InAs/CdSe core/shells, simulated stacking faults had to be added in the shell region for the thick InP shells (6.2 monolayers) to better reproduce the experimental pattern. On average, it was found that a stacking fault exists every four to five layers in InAs core/shell nanocrystals (Table 1). In these stacking faults the bonds of atoms remain fully saturated and charge carrier traps do not necessarily form so it is likely that these planar stacking faults do not substantially reduce the fluorescence QY.

### 4. Model calculations for the band gap

The core/shell band offsets provide control for modifying the electronic and optical properties of these composite nanocrystals. To examine the effect of the band offsets of various shells on the band gap of the composite nanocrystals, calculations were performed using a particle in a spherical box model. This model has been reported previously for other composite nanocrystals [Dabbousi, B.O., *et al., ibid.;* Schoos, D., et al., Phys. Rev. B 1994, 49, 17072]. Briefly, in this model the electron and hole wavefunctions are treated separately, and the coulomb interaction is then added within first order perturbation theory [Brus, L.E., J. Chem. Phys. 1984, 80, 4403]. Three radial potential regions should be considered in the core/shell nanocrystals: core, shell and the surrounding organic layer. Continuity is required for the radial part of the wavefunctions for both electron and hole at the interfaces. In addition, the probability current is required to be continuous. This probability current can be expressed as $\frac{1}{m_i^*} \frac{d}{dr} R_i(k_i r)$, where $m_i^*$ is the effective mass in region i, $R_i$ is the radial part of the lowest energy $1S_{e/h}$ electron or hole wavefunction, and $k_i$ is the wave vector in region i. The effective masses and dielectric constants of the bulk semiconductors were used in the calculations [see O. Madelung *et al*]. The band offsets were taken from S. Wei *et al.* For InAs cores having 1.7 nm radii, a barrier height of 4.5 eV was used for the surrounding organic layer for both carriers. The confinement energy for the electron is sensitive to the barrier height because of the small electron effective mass, while the heavier hole is much less sensitive. The experimental value is in reasonable agreement with the calculated band gap, within the limitations of this simplistic model [Williamson, A.J., et al., Phys. Rev. B 1999, 59, 15819]. As the interesting value is the relative change of the band gap upon growth of the different shells, the calculated and measured shifts in the band gap for various core/shells were plotted, as shown in Fig. 9. The error in the band gap shifts should be small compared with that in the absolute band gap energies and the agreement for the band gap shifts are good. For the ZnS shells (dot-dashed line), hardly any shift is observed in both the experimental and the calculated values. This is consistent with the large band offsets between InAs and ZnS. For both InP (dashed line) and CdSe (solid line) shells, the experimental and the calculated band gaps shift to the red upon shell growth. This is mainly attributed to the reduction in the electron confinement energy in these core/shells. The lowest $1S_e$ level of the electron is above the core/shell barrier for both InP and CdSe shells leading to a high probability of presence of the electron in the shells.

### 5. Stability of core/shell nanocrystals

Core/shell passivation with a shell of a semiconductor material that has large band offsets compared with the core, should provide increased protection and stability compared with the organically passivated core nanocrystals. The photostability of the core/shells were compared to IR140, a typical near IR organic laser dye [Leduc, M., et al., C. Optics Commun. 1978, 26, 78]. Solutions of nanocrystals and of the dye saturated with oxygen, were irradiated at 810 nm with a 250 mW Ti-Sapphire laser for half an hour, and the optical density of the irradiated solutions was 0.2 at 810 nm. Under these conditions, each nanocrystal and dye molecule absorbs a total of approximately $0.5*10^6$ photons. For the dye, following the irradiation, the main absorption peak at 830 nm vanished, indicating that the dye completely degraded. For InAs cores (radius 1.7 nm), the absorption maximum shifted to the blue by 10 nm and the optical density slightly decreased. The PL intensity decreased by a factor of 2.1. For InAs/ZnSe core/shells (core radius 1.7 nm, shell thickness ~2 monolayers), the absorption did not change upon irradiation, and the PL intensity decreased by a factor of 1.7, to a value still eight times stronger than for the fresh core. Finally, for InAs/CdSe core/shells (core radius 1.7 nm, shell thickness ~1.8 monolayers) the absorption shifted to the blue by 5 nm, and the PL intensity decreased by only 10%. This experiment demonstrates the improved photostability of the core/shells compared with a typical near IR laser dye.

These core/shells also display greatly increased stability against oxidation compared with the bare cores. The stability of the bare (TOP coated) InAs cores and the two core/shell samples similar to the ones examined above were studied. Absorption and emission spectra of the fresh samples, and of samples that were kept for ten months in a solution saturated with oxygen and exposed to ambient light conditions were compared. The results are summarized in Fig. 10. The InAs cores under these conditions exhibited a considerable blue shift of the absorption accompanied by a washing out of the spectral features. The emission was quenched by a factor of 40 compared with the fresh cores (Fig. 10A). These phenomena indicate substantial oxidation of the bare cores. The core/shells under similar conditions show a very different behavior. For InAs/CdSe core/shells the absorption shifted slightly to the blue and the QY decreases from 16% to 13% (Fig. 10B). Finally, for the InAs/ZnSe core/shells, the absorption hardly shifts and the emission QY is reduced from 19% to 15% (Fig. 10C).

### Claims

1. A method for the preparation of core/shell nanocrystals comprising an InAs nanocore encapsulated in a crystalline shell comprised of GaAs or InP; comprising the following steps :

   (i) preparing a first stock precursor solution of In:As for nanocrystal cores having a molar ratio of In:As to nucleate InAs nanocrystals therefrom;
   (ii) preparing a second stock precursor solution of a shell material for nanocrystal shells of either GaAs or InP, the second stock precursor solution containing, in the case of GaAs shells, Ga:As in the molar ratio of 4:1 or, in the case of InP shells, In:P in a molar ratio from 1.2:1 to 1.5:1;
   (iii) injecting said first stock precursor solution at room temperature into TOP or TOP/TOPO solution at temperature above room temperature to nucleate core nanocrystals, with addition of further stock precursor solution as necessary, to achieve desired core dimensions;
   (iv) precipitating core nanocrystals; and
   (v) contacting the nanocrystals obtained in step (iv) with said second stock precursor solution of shell material in a TOP/TOPO solution to allow for growth of said shell on said core at a temperature of above 240°C.

2. A method according to claim 1, **characterised in that** the core/shell nanocrystal is coated with an organic ligand on the outer surface thereof.

3. A method according to claim 1 or 2, **characterised in that** first precursor stock solution of InAs cores contains In: As at a molar ratio of from 1:2 to 1:1.5.

### Patentansprüche

1. Verfahren zur Herstellung von Kern-/Mantel-Nanokristallen, die einen InAs-Nanokern umfassen, der in einem kristallen Mantel eingekapselt ist, der aus GaAs oder InP besteht; umfassend die folgenden Schritte:

   (i) Herstellen einer ersten Vorläuferstammlösung von In:As für Nanokristallkerne mit einem Molverhältnis von In:As, um Keime für InAs-Nanokristalle daraus zu bilden;

(ii) Herstellen einer zweiten Vorläuferstammlösung eines Mantelmaterials für Nanokristallmäntel entweder von GaAs oder InP, wobei die zweite Vorläuferstammlösung, im Falle von GaAs-Mänteln, Ga:As im Molverhältnis von 4:1 oder, im Falle von InP-Mänteln, In:P in einem Molverhältnis von 1,2:1 bis 1,5:1 enthält;

(iii) Injizieren der ersten Vorläuferstammlösung bei Raumtemperatur in eine TOP- oder TOP/TOPO-Lösung bei einer Temperatur über Raumtemperatur, um Keime für Kern-Nanokristalle zu bilden, bei Zugabe von weiterer Vorläuferstammlösung nach Bedarf, um die erwünschten Kernabmessungen zu erreichen;

(iv) Abscheiden von Kern-Nanokristallen; und

(v) In-Kontakt-bringen der in Schritt (iv) erhaltenen Nanokristalle mit der zweiten Vorläuferstammlösung von Mantelmaterial in einer TOP/TOPO-Lösung, um das Wachstum des Mantels auf dem Kern bei einer Temperatur von über 240 °C zu ermöglichen.

**2.** Verfahren nach Anspruch 1, **dadurch gekennzeichnet, dass** der Kern-/Mantel-Nanokristall auf der Außenfläche davon mit einem organischen Liganden beschichtet wird.

**3.** Verfahren nach Anspruch 1 oder 2, **dadurch gekennzeichnet, dass** die erste Vorläuferstammlösung von InAs-Kernen InAs in einem Molverhältnis von 1:2 bis 1:1,5 enthält.

**Revendications**

**1.** Procédé de préparation de nanocristaux à structure coeur/coquille comprenant un nanocoeur d'InAs encapsulé dans une coquille cristalline constituée de GaAs ou d'InP ;

comprenant les étapes suivantes :

(i) la préparation d'une première solution mère précurseur d'In/As pour le coeur des nanocristaux ayant un rapport molaire In/As permettant la nucléation de nanocristaux d'InAs à partir de celle-ci ;

(ii) la préparation d'une deuxième solution mère précurseur de la matière qui constitue la coquille pour la coquille des nanocristaux de GaAs ou d'InP, la deuxième solution mère précurseur contenant, dans le cas des coquilles de GaAs, du Ga/As dans le rapport molaire de 4/1 ou, dans le cas des coquilles d'InP, de l'In/P dans un rapport molaire de 1,2/1 à 1,5/1 ;

(iii) l'injection de ladite première solution mère précurseur à température ambiante dans une solution de TOP ou de TOP/TOPO à une température supérieure à la température ambiante afin de réaliser la nucléation du coeur des nanocristaux, avec addition d'une quantité supplémentaire de solution mère précurseur selon les besoins, pour obtenir les dimensions souhaitées du coeur ;

(iv) la précipitation du coeur des nanocristaux ; et

(v) la mise en contact des nanocristaux obtenus dans l'étape (iv) avec ladite deuxième solution mère précurseur de la matière qui constitue la coquille dans une solution de TOP/TOPO pour permettre la croissance de ladite coquille sur ledit coeur à une température supérieure à 240 °C.

**2.** Procédé selon la revendication 1, **caractérisé en ce que** le nanocristal à structure coeur/coquille est recouvert d'un ligand organique sur sa surface externe.

**3.** Procédé selon la revendication 1 ou 2, **caractérisé en ce que** la première solution mère précurseur des coeurs d'InAs contient de l'In/As dans un rapport molaire de 1/2 à 1/1,5.

Fig. 1

Fig. 2

Fig. 3

Fig. 4

Fig. 5

Fig. 6

Fig. 7

Fig. 8

Fig. 9

Fig. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0017655 A

### Non-patent literature cited in the description

- **Nirmat et al.** *Acc. Chem. Res.,* 1999, vol. 32, 407
- **Alivisatos A. P.** *Science,* 1996, vol. 271, 933
- **Weller H.** *Angew. Chem. Int. Ed. Engl.,* 1993, vol. 32, 41
- **Banin U. et al.** *Nature,* 1999, vol. 400, 542
- **Bruchez M. et al.** *Science,* 1998, vol. 281, 2013
- **Chan W.C.W. et al.** *Science,* 1998, vol. 281, 2016
- **Mitchell G.P. et al.** *J. Am. Chem. Soc.,* 1999, vol. 121, 8122
- **Colvin V.L. et al.** *Nature,* 1994, vol. 370, 354
- **Dabboussi B.O. et al.** *Appl. Phys. Lett.,* 1995, vol. 66, 1316
- **Schlamp, M.C. et al.** *J. Appl. Phys.,* 1997, vol. 82, 5837
- **Mattoussi H. et al.** *J. Appl. Phys.,* 1998, vol. 83, 7965
- **Kuno M. et al.** *J. Chem. Phys.,* 1997, vol. 106, 9869
- **Hines, M. A. et al.** *J. Phys. Chem.,* 1996, vol. 100, 468
- **Peng, X. et al.** *J. Am. Chem. Soc.,* 1997, vol. 119, 7019
- **Dabbousi, B.O. et al.** *J. Phys. Chem. B.,* 1997, vol. 101, 9463
- **Tian, Y. et al.** *J. Phys. Chem.,* 1996, vol. 100, 8927
- **Cao, Y.W. et al.** *Angew. Chem. Int. Ed. Engl.,* 1999, vol. 38, 3692
- **Cao Y.W. ; Banin U.** *Angew. Chem. Int. Ed. Engl.,* 1999, vol. 38, 3692
- **Murray, C.B. et al.** *J. Am. Chem. Soc.,* 1993, vol. 115, 8706
- **Micic, O.I. et al.** *J. Phys. Chem.,* 1994, vol. 98, 4966
- **Nozik, A.J. et al.** *MRS Bull.,* 1998, vol. 23, 24
- **Guzelian, A.A.** *J. Phys. Chem.,* 1996, vol. 100, 7212
- **Guzelian, A.A. et al.** *Appl. Phys. Lett.,* vol. 69, 1462
- **Peng, X. et al.** *A. P. J. Am. Chem. Soc.,* 1998, vol. 120, 5343
- **Cao Y. W. et al.** *Mat.Res.Soc.Symp.Proc.,* 2000, vol. 571, 75-80
- **Guzelian, A.A. et al.** *J. Phys. Chem.,* 1996, vol. 100, 7212
- **Becker, G. et al.** *Anorg. Allg. Chem.,* 1980, vol. 462, 113
- **Guzelian, A.A.** *Appl. Phys. Lett.,* 1996, vol. 69, 1462
- **Peng, X.** *J. Am. Chem. Soc.,* 1998, vol. 120, 5343
- **Demas, J.N. et al.** *J. Phys. Chem.,* 1971, vol. 75, 991
- **Katari, J.E.B.** *J. Phys. Chem.,* 1994, vol. 98, 4109
- **Banin, U. et al.** *J. Chem. Phys.,* 1994, vol. 98, 4109
- Landolt-Bornstein: Numerical Data and Functional Relationships in Science and Technology. New Series. Springer-Verlag, 1982, vol. 17
- **Hoener, C.F. et al.** *J. Phys. Chem.,* 1992, vol. 96, 3812
- **Murray, C.B. et al.** *Science,* 1995, vol. 270, 1335
- **Guzelian, A.A. et al.** *Appl. Phys. Lett.,* 1996, vol. 69, 1462
- **Wickham, J.N. et al.** *Phys. Rev. Lett.,* 2000, vol. 84, 923
- **Wickham, J.N. et al.** *Private communication*
- **Mann, B.** *Acta Cryst.,* 1968, vol. A 24, 321
- **Schoos, D. et al.** *Phys. Rev. B,* vol. 49, 17072
- **Brus, L.E.** *J. Chem. Phys.,* 1984, vol. 80, 4403
- **Williamson, A.J. et al.** *Phys. Rev. B,* 1999, vol. 59, 15819
- **Leduc, M. et al.** *C. Optics Commun.,* 1978, vol. 26, 78